# EUROPEAN PATENT APPLICATION

(11) **EP 3 208 860 A1**
(43) Date of publication of application: **23.08.2017**
(21) Application number: 15851110.5
(22) Date of filing: 14.10.2015
(51) Int. Cl.: H01L 51/44

(54) **SOLAR CELL**

(30) Priority: 14.10.2014 JP 2014210186
(71) Applicant: Sekisui Chemical Co., Ltd., Osaka-shi, Osaka 530-0047 (JP)
(72) Inventor: HAYAKAWA Akinobu, Mishima-gun Osaka 618-0021 (JP); ASANO Motohiko, Mishima-gun Osaka 618-0021 (JP); UNO Tomohito, Mishima-gun Osaka 618-0021 (JP); HORIKI Mayumi, Mishima-gun Osaka 618-0021 (JP); FUKUMOTO Yuuichirou, Mishima-gun Osaka 618-0021 (JP); KUREBAYASHI Tetsuya, Mishima-gun Osaka 618-0021 (JP); OHARA Shunji, Mishima-gun Osaka 618-0021 (JP)
(74) Representative: Hart-Davis, Jason
(86) International application number: PCT/JP2015/079002
(87) International publication number: WO 2016/060154

(57) **Abstract**

The present invention aims to provide a solar cell that is excellent in photoelectric conversion efficiency, suffers little degradation during encapsulation (initial degradation), and has excellent durability. The present invention relates to a solar cell including: a laminate having an electrode, a counter electrode, and a photoelectric conversion layer disposed between the electrode and the counter electrode; and an inorganic layer covering the counter electrode to encapsulate the laminate, the photoelectric conversion layer including an organic-inorganic perovskite compound represented by the formula: R-M-X₃, R representing an organic molecule, M representing a metal atom, X representing a halogen atom or a chalcogen atom, the inorganic layer containing a metal oxide, a metal nitride, or a metal oxynitride.

## Description

### TECHNICAL FIELD

The present invention relates to a solar cell that is excellent in photoelectric conversion efficiency, suffers little degradation during encapsulation (initial degradation), and has excellent durability.

### BACKGROUND ART

Photoelectric conversion elements equipped with a laminate having an N-type semiconductor layer and a P-type semiconductor layer disposed between opposing electrodes have been conventionally developed. Such photoelectric conversion elements generate photocarriers by photoexcitation so that electrons and holes move through the N-type semiconductor and the P-type semiconductor, respectively, to create an electric field.

Most photoelectric conversion elements currently in practical use are inorganic solar cells which are produced using inorganic semiconductors made of silicon or the like. The inorganic solar cells, however, are utilized only in a limited range because their production is costly and upsizing thereof is difficult. Therefore, organic solar cells produced using organic semiconductors instead of inorganic semiconductors have received attention.

Fullerene is used in most organic solar cells. Fullerene is known to function mainly as an N-type semiconductor. For example, Patent Literature 1 discloses a semiconductor heterojunction film formed using an organic compound serving as a P-type semiconductor, and fullerenes. Fullerene, however, is known to be responsible for degradation of organic solar cells produced using the fullerene (see e.g., Non-Patent Literature 1). Thus, there is a demand for selecting a material with higher durability than fullerene.

In the organic solar cells, a laminate having an N-type semiconductor layer and a P-type semiconductor layer disposed between opposing electrodes is generally encapsulated using an encapsulation resin such as a sealing material (see e.g., Non-Patent Literature 2). However, in an organic solar cell encapsulated with an encapsulation resin such as a sealing material, moisture penetrates into the inside through the encapsulation resin to degrade the N-type semiconductor layer, P-type semiconductor layer, or the like, resulting in insufficient durability of the organic solar cell.

### CITATION LIST

### - Patent Literature

Patent Literature 1: JP 2006-344794 A

### - Non-Patent Literature

Non-Patent Literature 1: Reese et al., Adv. Funct. Mater., 20, 3476-3483 (2010)
Non-Patent Literature 2: Proc. of SPIE Vol. 7416 74160K-1

### SUMMARY OF INVENTION

### - Technical Problem

An object of the present invention is to provide a solar cell that is excellent in photoelectric conversion efficiency, suffers little degradation during encapsulation (initial degradation), and has excellent durability.

### - Solution to problem

The present invention provides a solar cell including: a laminate having an electrode, a counter electrode, and a photoelectric conversion layer disposed between the electrode and the counter electrode; and an inorganic layer covering the counter electrode to encapsulate the laminate, the photoelectric conversion layer including an organic-inorganic perovskite compound represented by the formula R-M-X₃, R representing an organic molecule, M representing a metal atom, X representing a halogen atom or a chalcogen atom, the inorganic layer containing a metal oxide, a metal nitride, or a metal oxynitride.

Hereinafter, the present invention will be described in detail.

The present inventors found out that encapsulation of a laminate having an electrode, a counter electrode, and a photoelectric conversion layer disposed between the electrode and the counter electrode with an inorganic layer covering the counter electrode can improve the durability of the resulting solar cell. This is presumably because encapsulation with an inorganic layer having a water vapor barrier property can suppress moisture penetration into the inside compared to a case where encapsulation is performed with an encapsulation resin.

In encapsulation with an inorganic layer, for example, a sputtering method or the like is suitably employed to form a dense layer. However, when the photoelectric conversion layer contains an organic semiconductor such as fullerene, the organic semiconductor is degraded during encapsulation by the sputtering method to lower the photoelectric conversion efficiency (initial degradation). To overcome the situation, the present inventors found out that use of a particular organic-inorganic perovskite compound for a photoelectric conversion layer hardly causes initial degradation even when a dense inorganic layer is formed by a sputtering method or the like. A solar cell including a photoelectric conversion layer prepared using an organic-inorganic perovskite compound is also excellent in photoelectric conversion efficiency.

The present inventors found out that use of a particular organic-inorganic perovskite compound for a photoelectric conversion layer and encapsulation of a laminate including the photoelectric conversion layer with an inorganic layer containing a metal oxide, a metal nitride, or a metal oxynitride can provide a solar cell with improved durability, while enhancing photoelectric conversion efficiency and suppressing degradation during encapsulation (initial degradation). The present invention was thus completed.

The solar cell of the present invention includes: a laminate having an electrode, a counter electrode, and a photoelectric conversion layer disposed between the electrode and the counter electrode; and an inorganic layer covering the counter electrode to encapsulate the laminate.

The term "layer" as used herein means not only a layer having a clear boundary, but also a layer having a concentration gradient in which contained elements are gradually changed. The elemental analysis of the layer can be conducted, for example, by FE-TEM/EDS analysis and measurement of the cross section of the solar cell to confirm the element distribution of a particular element. The term "layer" as used herein means not only a flat thin film-shaped layer, but also a layer capable of forming an intricate structure together with other layer(s).

The materials of the electrode and the counter electrode are not particularly limited, and conventionally known materials may be used. The counter electrode is often a patterned electrode. When the counter electrode is a patterned electrode, the inorganic layer also covers the photoelectric conversion layer to encapsulate the laminate.

Examples of the materials of the electrode and the counter electrode include fluorine-doped tin oxide (FTO), sodium, sodium-potassium alloys, lithium, magnesium, aluminum, magnesium-silver mixtures, magnesium-indium mixtures, aluminum-lithium alloys, Al/Al₂O₃ mixtures, Al/LiF mixtures, metals such as gold, CuI, conductive transparent materials such as indium tin oxide (ITO), SnO₂, aluminum zinc oxide (AZO), indium zinc oxide (IZO) and gallium zinc oxide (GZO), and conductive transparent polymers. These materials may be used alone or may be used in combination of two or more thereof.

The electrode and the counter electrode may each be either a cathode or an anode.

The photoelectric conversion layer includes an organic-inorganic perovskite compound represented by the formula R-M-X₃ wherein R represents an organic molecule, M represents a metal atom, and X represents a halogen atom or a chalcogen atom.

Use of the organic-inorganic perovskite compound in the photoelectric conversion layer can enhance the photoelectric conversion efficiency and improve the durability of the solar cell while suppressing the degradation during encapsulation (initial degradation).

The R is an organic molecule and is preferably represented by C₁NₘHₙ (1, m and n each represent a positive integer).

Specific examples of the R include methylamine, ethylamine, propylamine, butylamine, pentylamine, hexylamine, dimethylamine, diethylamine, dipropylamine, dibutylamine, dipentylamine, dihexylamine, trimethylamine, triethylamine, tripropylamine, tributylamine, tripentylamine, trihexylamine, ethylmethylamine, methylpropylamine, butylmethylamine, methylpentylamine, hexylmethylamine, ethylpropylamine, ethylbutylamine, guanidine, formamidine, imidazole, azole, pyrrole, aziridine, azirine, azetidine, azete, azole, imidazoline, carbazole and their ions (e.g., methylammonium (CH₃NH₃)), and phenethylammonium. Among them, methylamine, formamidine, ethylamine, propylamine, butylamine, pentylamine, hexylamine and their ions, and phenethylammonium are preferred, and methylamine, formamidine, ethylamine, propylamine and their ions are more preferred.

The M is a metal atom. Examples thereof include lead, tin, zinc, titanium, antimony, bismuth, nickel, iron, cobalt, silver, copper, gallium, germanium, magnesium, calcium, indium, aluminum, manganese, chromium, molybdenum, and europium. These metal atoms may be used alone or may be used in combination of two or more thereof.

The X is a halogen atom or a chalcogen atom. Examples thereof include chlorine, bromine, iodine, sulfur, and selenium. These halogen atoms or chalcogen atoms may be used alone or may be used in combination of two or more thereof. Among them, a halogen atom is preferred because the organic-inorganic perovskite compound containing halogen in the structure is soluble in an organic solvent and is usable in an inexpensive printing method or the like. In addition, iodine is more preferred because the organic-inorganic perovskite compound has a narrow energy band gap.

The organic-inorganic perovskite compound preferably has a cubic structure where the metal atom M is placed at the body center, the organic molecule R is placed at each vertex, and the halogen atom or chalcogen atom X is placed at each face center.

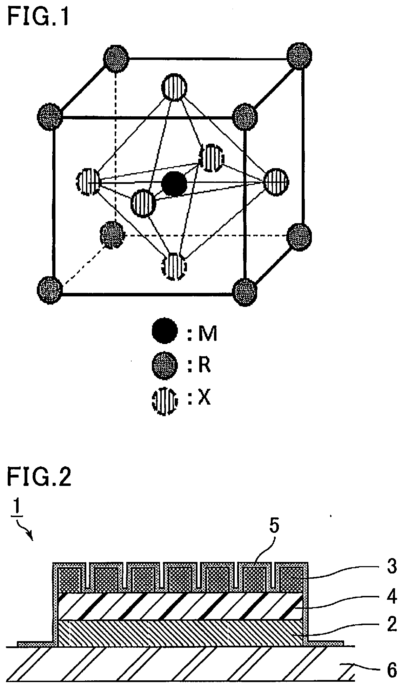

Fig. 1 is a schematic view illustrating an exemplary crystal structure of the organic-inorganic perovskite compound having a cubic structure where the metal atom M is placed at the body center, the organic molecule R is placed at each vertex, and the halogen atom or chalcogen atom X is placed at each face center. Although details are not clear, it is presumed that the direction of an octahedron in the crystal lattice can be easily changed owing to the structure; thus the mobility of electrons in the organic-inorganic perovskite compound is enhanced, improving the photoelectric conversion efficiency of the solar cell.

The organic-inorganic perovskite compound is preferably a crystalline semiconductor. The crystalline semiconductor means a semiconductor whose scattering peak can be detected by the measurement of X-ray scattering intensity distribution. When the organic-inorganic perovskite compound is a crystalline semiconductor, the mobility of electrons in the organic-inorganic perovskite compound is enhanced, improving the photoelectric conversion efficiency of the solar cell.

The degree of crystallinity can also be evaluated as an index of crystallization. The degree of crystallinity can be determined by separating a crystalline substance-derived scattering peak from an amorphous portion-derived halo, which are detected by X-ray scattering intensity distribution measurement, by fitting, determining their respective intensity integrals, and calculating the ratio of the crystalline portion to the whole.

The lower limit of the degree of crystallinity of the organic-inorganic perovskite compound is preferably 30%. When the degree of crystallinity is 30% or more, the mobility of electrons in the organic-inorganic perovskite compound is enhanced, improving the photoelectric conversion efficiency of the solar cell. The lower limit of the degree of crystallinity is more preferably 50%, further preferably 70%.

Examples of the method for increasing the degree of crystallinity of the organic-inorganic perovskite compound include heat annealing, irradiation with light having strong intensity, such as laser, and plasma irradiation.

The photoelectric conversion layer may further include an organic semiconductor or an inorganic semiconductor, in addition to the organic-inorganic perovskite compound, without impairing the effects of the present invention. In this context, the organic semiconductor or the inorganic semiconductor may play a role as an electron transport layer or a hole transport layer mentioned later.

Examples of the organic semiconductor include compounds having a thiophene skeleton, such as poly(3-alkylthiophene). Examples thereof also include conductive polymers having a poly-p-phenylenevinylene skeleton, a polyvinylcarbazole skeleton, a polyaniline skeleton, a polyacetylene skeleton or the like. Examples thereof further include: compounds having a phthalocyanine skeleton, a naphthalocyanine skeleton, a pentacene skeleton, a porphyrin skeleton such as a benzoporphyrin skeleton, a spirobifluorene skeleton or the like; and carbon-containing materials such as carbon nanotube, graphene, and fullerene, which may be surface-modified.

Examples of the inorganic semiconductor include titanium oxide, zinc oxide, indium oxide, tin oxide, gallium oxide, tin sulfide, indium sulfide, zinc sulfide, CuSCN, Cu₂O, CuI, MoO₃, V₂O₅, WO₃, MoS₂, MoSe₂ and Cu₂S.

The photoelectric conversion layer including the organic semiconductor or the inorganic semiconductor may be a laminated structure where a thin film-shaped organic semiconductor or inorganic semiconductor part and a thin film-shaped organic-inorganic perovskite compound part are laminated, or may be a composite structure where an organic semiconductor or inorganic semiconductor part and an organic-inorganic perovskite compound part are combined. The laminated structure is preferred from the viewpoint that the production process is simple. The composite structure is preferred from the viewpoint that the charge separation efficiency of the organic semiconductor or the inorganic semiconductor can be improved.

The lower limit of the thickness of the thin film-shaped organic-inorganic perovskite compound part is preferably 5 nm, and the upper limit thereof is preferably 5,000 nm. When the thickness is 5 nm or larger, light can be sufficiently absorbed, enhancing the photoelectric conversion efficiency. When the thickness is 5,000 nm or smaller, presence of a region in which charge separation cannot be achieved can be avoided, leading to higher photoelectric conversion efficiency. The lower limit of the thickness is more preferably 10 nm, and the upper limit thereof is more preferably 1,000 nm. The lower limit of the thickness is further preferably 20 nm, and the upper limit thereof is further preferably 500 nm.

When the photoelectric conversion layer is a composite structure where an organic semiconductor or inorganic semiconductor part and an organic-inorganic perovskite compound part are combined, the lower limit of the thickness of the composite structure is preferably 30 nm, and the upper limit thereof is preferably 3,000 nm. When the thickness is 30 nm or larger, light can be sufficiently absorbed, enhancing the photoelectric conversion efficiency. When the thickness is 3,000 nm or smaller, charge easily arrives at the electrode, enhancing the photoelectric conversion efficiency. The lower limit of the thickness is more preferably 40 nm, and the upper limit thereof is more preferably 2,000 nm. The lower limit of the thickness is further preferably 50 nm, and the upper limit thereof is further preferably 1,000 nm.

In the laminate, an electron transport layer may be disposed between the electrode and the photoelectric conversion layer.

Examples of the material for the electron transport layer include, but are not particularly limited to, N-type conductive polymers, N-type low-molecular organic semiconductors, N-type metal oxides, N-type metal sulfides, alkali metal halides, alkali metals, and surfactants. Specific examples thereof include cyano group-containing polyphenylenevinylene, boron-containing polymers, bathocuproine, bathophenanthroline, hydroxyquinolinatoaluminum, oxadiazole compounds, benzimidazole compounds, naphthalenetetracarboxylic acid compounds, perylene derivatives, phosphine oxide compounds, phosphine sulfide compounds, fluoro group-containing phthalocyanine, titanium oxide, zinc oxide, indium oxide, tin oxide, gallium oxide, tin sulfide, indium sulfide, and zinc sulfide.

The electron transport layer may consist only of a thin film-shaped electron transport layer and preferably includes a porous electron transport layer. Particularly, when the photoelectric conversion layer is a composite structure where an organic semiconductor or inorganic semiconductor part and an organic-inorganic perovskite compound part are combined, a film of the composite structure is preferably formed on a porous electron transport layer because a more complicated composite structure (more intricate structure) is obtained, enhancing the photoelectric conversion efficiency.

The lower limit of the thickness of the electron transport layer is preferably 1 nm, and the upper limit thereof is preferably 2,000 nm. When the thickness is 1 nm or larger, holes can be sufficiently blocked. When the thickness is 2,000 nm or smaller, the layer is less likely to be the resistance to the electron transport, enhancing the photoelectric conversion efficiency. The lower limit of the thickness of the electron transport layer is more preferably 3 nm, and the upper limit thereof is more preferably 1,000 nm. The lower limit of the thickness is further preferably 5 nm, and the upper limit thereof is further preferably 500 nm.

In the laminate, a hole transport layer may be disposed between the counter electrode and the photoelectric conversion layer.

Examples of the material of the hole transport layer include, but are not particularly limited to, P-type conductive polymers, P-type low-molecular organic semiconductors, P-type metal oxides, P-type metal sulfides, and surfactants. Specific examples thereof include polystyrenesulfonic acid adducts of polyethylenedioxythiophene, carboxyl group-containing polythiophene, phthalocyanine, porphyrin, molybdenum oxide, vanadium oxide, tungsten oxide, nickel oxide, copper oxide, tin oxide, molybdenum sulfide, tungsten sulfide, copper sulfide, tin sulfide, fluoro group-containing phosphonic acid, carbonyl group-containing phosphonic acid, copper compounds such as CuSCN and CuI, and carbon-containing materials such as carbon nanotube and graphene.

The lower limit of the thickness of the hole transport layer is preferably 1 nm, and the upper limit thereof is preferably 2,000 nm. When the thickness is 1 nm or larger, electrons can be sufficiently blocked. When the thickness is 2,000 nm or smaller, the layer is less likely to be the resistance to the hole transport, enhancing the photoelectric conversion efficiency. The lower limit of the thickness is more preferably 3 nm, and the upper limit thereof is more preferably 1,000 nm. The lower limit of the thickness is further preferably 5 nm, and the upper limit thereof is further preferably 500 nm.

The laminate may further have a substrate or the like. Examples of the substrate include, but are not particularly limited to, transparent glass substrates such as soda lime glass and alkali-free glass substrates, ceramic substrates, transparent plastic substrates, and metal foils.

In the solar cell of the present invention, the laminate is encapsulated with an inorganic layer covering the counter electrode.

Encapsulation of the laminate with the inorganic layer covering the counter electrode can improve the durability of the solar cell. This is probably because encapsulation with the inorganic layer having a water vapor barrier property can suppress moisture penetration into the inside compared to the case where encapsulation is performed using an encapsulation resin. In this context, the inorganic layer preferably covers the laminate entirely so as to close the end portions thereof. This can reliably prevent moisture penetration into the inside.

In encapsulation with the inorganic layer, for example, a sputtering method or the like is suitably employed to form a dense layer. However, when the photoelectric conversion layer contains an organic semiconductor such as fullerene, the organic semiconductor is degraded during encapsulation by the sputtering method to lower the photoelectric conversion efficiency (initial degradation). By contrast, in the solar cell of the present invention, a photoelectric conversion layer containing the organic-inorganic perovskite compound exhibits excellent photoelectric conversion efficiency and suppresses degradation during encapsulation (initial degradation) to improve the durability of the resulting solar cell.

In a case where an encapsulation resin such as a conventional epoxy resin, not the inorganic layer, is used for encapsulation and the organic-inorganic perovskite compound is used for the photoelectric conversion layer, the solar cell suffers not only insufficient durability but also degradation during encapsulation (initial degradation). This is presumably because an organic component of the organic-inorganic perovskite compound is dissolved in the encapsulation resin.

The inorganic layer contains a metal oxide, a metal nitride, or a metal oxynitride.

The metal oxide, metal nitride, or metal oxynitride is not particularly limited as long as it has a water vapor barrier property. Examples thereof include an oxide, a nitride, or an oxynitride of Si, Al, Zn, Sn, In, Ti, Mg, Zr, Ni, Ta, W, Cu, or an alloy containing two or more of them. Among them, an oxide, a nitride, or an oxynitride of Si, Al, Zn, or Sn is preferred, and an oxide, a nitride, or an oxynitride of Zn or Sn is more preferred. An oxide, a nitride, or an oxynitride of metal elements including both of the metal elements Zn and Sn is further preferred because a particularly high water vapor barrier property and plasticity can be imparted to the inorganic layer.

Among others, the metal oxide, metal nitride, or metal oxynitride is particularly preferably a metal oxide represented by the formula ZnₐSn_{b}O_{c}. In this formula, a, b and c each represent a positive integer.

Use of the metal oxide represented by the formula ZnₐSn_{b}O_{c} in the inorganic layer can impart moderate flexibility to the inorganic layer because the metal oxide contains a tin (Sn) atom, so that stress is decreased even when the thickness of the inorganic layer is increased. Therefore, peeling of the inorganic layer, electrode, semiconductor layer, and the like can be suppressed. This can enhance the water vapor barrier property of the inorganic layer and further improve the durability of the solar cell. Meanwhile, the inorganic layer can exert a particularly high barrier property because the metal oxide contains a zinc (Zn) atom.

In the metal oxide represented by the formula ZnₐSn_{b}O_{c}, the ratio Xs (% by weight) of Sn to the total sum of Zn and Sn preferably satisfies 70 > Xs > 0. Also, value Y represented by Y = c / (a + 2b) preferably satisfies 1.5 > Y > 0.5.

The element ratios of zinc (Zn), tin (Sn), and oxygen (O) contained in the metal oxide represented by the formula ZnₐSn_{b}O_{c} in the inorganic layer can be measured using an X-ray photoemission spectroscopy (XPS) surface analyzer (e.g., ESCALAB-200R available from VG Scientific).

Preferably, the inorganic layer containing the metal oxide represented by the formula ZnₐSn_{b}O_{c} further contains silicon (Si) and/or aluminum (Al).

The addition of silicon (Si) and/or aluminum (Al) to the inorganic layer can enhance the transparency of the inorganic layer and improve the photoelectric conversion efficiency of the solar cell.

The lower limit of the thickness of the inorganic layer is preferably 30 nm, and the upper limit thereof is preferably 3,000 nm. When the thickness is 30 nm or larger, the inorganic layer can have an adequate water vapor barrier property, improving the durability of the solar cell. When the thickness is 3,000 nm or smaller, only small stress is generated even when the thickness of the inorganic layer is increased. Therefore, peeling of the inorganic layer, electrode, semiconductor layer, and the like can be suppressed. The lower limit of the thickness is more preferably 50 nm, and the upper limit thereof is more preferably 1,000 nm. The lower limit of the thickness is further preferably 100 nm, and the upper limit thereof is further preferably 500 nm.

The thickness of the inorganic layer can be measured using an optical interference-type film thickness measurement apparatus (e.g., FE-3000 available from Otsuka Electronics Co., Ltd.).

The solar cell of the present invention preferably further includes a planarizing resin layer between the counter electrode and the inorganic layer. Inclusion of such a planarizing resin layer allows the solar cell of the present invention to exhibit higher durability.

In a case where the planarizing resin layer is included, the inorganic layer may be disposed also between the counter electrode and the planarizing resin layer. With such a configuration, the durability of the solar cell of the present invention can be further improved.

The resin forming the planarizing resin layer is not particularly limited, and may be any of a thermoplastic resin, a thermosetting resin, and a photocurable resin. The thermoplastic resin may be, for example, a butyl rubber, polyester, polyurethane, polyethylene, polypropylene, polyvinyl chloride, polystyrene, polyvinyl alcohol, polyvinyl acetate, ABS resin, polybutadiene, polyamide, polycarbonate, polyimide, polyisobutylene, or cycloolefin resin. The thermosetting resin may be, for example, an epoxy resin, acrylic resin, silicone resin, phenolic resin, melamine resin, or urea resin. The photocurable resin may be, for example, an acrylic resin, vinyl resin, or enethiol resin.

The planarizing resin layer preferably contains a resin having an alicyclic skeleton.

The alicyclic skeleton is not particularly limited, and examples thereof include norbornene, isobornene, adamantane, cyclohexane, dicyclopentadiene, dicyclohexane, and cyclopentane skeletons. Each of these skeletons may be used alone, or in combination of two or more thereof.

The resin having an alicyclic skeleton is not particularly limited as long as it has an alicyclic skeleton, and may be any of a thermoplastic resin, a thermosetting resin, and a photocurable resin. These resins having an alicyclic skeleton may be used alone, or in combination of two or more thereof.

The resin having an alicyclic skeleton may also be a resin obtained by forming a resin having a reactive functional group into a film, followed by a crosslinking reaction of the reactive functional group.

Examples of the resin having an alicyclic skeleton include a norbornene resin (TOPAS6013, available from Polyplastics Co., Ltd.), TOPAS series (available from Polyplastics Co., Ltd.), and polymers of adamantane acrylate (available from Mitsubishi Gas Chemical Company, Inc.).

To form the planarizing resin layer, the resin having an alicyclic skeleton may be used in admixture with a resin not having an alicyclic skeleton.

The lower limit of the thickness of the planarizing resin layer is preferably 100 nm, and the upper limit thereof is preferably 100,000 nm. When the thickness is 100 nm or more, the planarizing resin layer can sufficiently cover the counter electrode. When the thickness is 100,000 nm or less, water vapor penetration through a side face of the planarizing resin layer can be sufficiently blocked. The lower limit of the thickness is more preferably 500 nm, and the upper limit thereof is more preferably 50,000 nm. The lower limit is further preferably 1,000 nm, and the upper limit is further preferably 2,000 nm.

The solar cell of the present invention preferably further includes an encapsulation resin layer on the inorganic layer. With this configuration, the durability of the solar cell can be further improved.

The resin forming the encapsulation resin layer is not particularly limited, and may be an epoxy resin, acrylic resin, silicone resin, phenolic resin, melamine resin, urea resin, butyl rubber, polyester, polyurethane, polyethylene, polypropylene, polyvinyl chloride, polystyrene, polyvinyl alcohol, polyvinyl acetate, ABS resin, polybutadiene, polyamide, polycarbonate, polyimide, polyisobutylene, or fluororesin. Among these, the resin is preferably a silicone resin, butyl rubber, polyethylene, polypropylene, polystyrene, polybutadiene, or polyisobutylene because the encapsulation resin is less likely to dissolve an organic component of the organic-inorganic perovskite compound therein even when the inorganic layer has a crack or the like.

The lower limit of the thickness of the encapsulation resin is preferably 100 nm, and the upper limit thereof is preferably 100,000 nm. The lower limit of the thickness is more preferably 500 nm, and the upper limit thereof is more preferably 50,000 nm. The lower limit is further preferably 1,000 nm, and the upper limit is further preferably 20,000 nm.

In the solar cell of the present invention, a glass sheet, resin film, inorganic material-coated resin film, or metal foil such as aluminum foil is preferably disposed on the inorganic layer or on the encapsulation resin layer in the case where the encapsulation resin layer is disposed on the inorganic layer. With this configuration, the durability of the solar cell can be further improved. In particular, an inorganic material-coated resin film is more preferably disposed.

Fig. 2 is a cross-sectional view schematically illustrating an exemplary solar cell of the present invention.

In a solar cell 1 shown in Fig. 2, a laminate having, on a substrate 6, an electrode 2, a counter electrode 3, and a photoelectric conversion layer 4 disposed between the electrode 2 and the counter electrode 3 is encapsulated with an inorganic layer 5 that covers the entire laminate. In this context, the end portions of the inorganic layer 5 are closed by intimate contact with the substrate 6. Though not illustrated in Fig. 2, an encapsulation resin layer may be disposed to cover the inorganic layer 5, or a metal layer may be disposed on the inorganic layer 5 or the encapsulation resin layer. Further, a planarizing resin layer may be disposed between the laminate and the inorganic layer 5.

Examples of the method for producing the solar cell of the present invention include, but are not particularly limited to, a method which involves forming the electrode, the photoelectric conversion layer, and the counter electrode in this order on the substrate to prepare a laminate, then encapsulating the laminate with the inorganic layer, and further covering the inorganic layer with an encapsulation resin.

Examples of the method for forming the photoelectric conversion layer include, but are not particularly limited to, a vapor deposition method, a sputtering method, a chemical vapor deposition (CVD) method, an electrochemical deposition method, and a printing method. Among them, employment of a printing method allows simple formation of a large-area solar cell that can exhibit high photoelectric conversion efficiency. Examples of the printing method include a spin coating method and a casting method. Examples of the method using the printing method include a roll-to-roll method.

The method for encapsulating the laminate with the inorganic layer is preferably a vacuum deposition method, a sputtering method, a chemical vapor deposition (CVD) method, or an ion plating method. Among them, a sputtering method is preferred for forming a dense layer. The sputtering method is more preferably a DC magnetron sputtering method.

In the sputtering method, the inorganic layer can be formed by depositing raw materials including a metal target and oxygen gas or nitrogen gas on the counter electrode of the laminate for film formation.

The inorganic layer may be covered with an encapsulation resin by any method. Examples of the method include a method which involves sealing the inorganic layer using a sheet-shaped encapsulation resin, a method which involves applying an encapsulation resin solution containing the encapsulation resin dissolved in an organic solvent to the inorganic layer, a method which involves applying a compound having a reactive functional group that serves as the encapsulation resin to the inorganic layer, followed by cross-linking or polymerization of the compound having a reactive functional group using heat, UV, or the like, and a method which involves melting the encapsulation resin under heat, followed by cooling.

Examples of the reactive functional group include epoxy, alkenyl, alkoxy, and isocyanate groups.

### - Advantageous Effects of Invention

The present invention can provide a solar cell that is excellent in photoelectric conversion efficiency, suffers little degradation during encapsulation (initial degradation), and has excellent durability.

### BRIEF DESCRIPTION OF DRAWINGS

Fig. 1 is a schematic view illustrating an exemplary crystal structure of the organic-inorganic perovskite compound.
Fig. 2 is a cross-sectional view schematically illustrating an exemplary solar cell of the present invention.

### DESCRIPTION OF EMBODIMENTS

Hereinafter, the present invention will be described in more detail with reference to Examples. However, the present invention is not intended to be limited by these Examples.

### (Example 1)

### (Preparation of laminate)

A FTO film having a thickness of 1,000 nm was formed as an electrode on a glass substrate, ultrasonically washed with pure water, acetone, and methanol each for ten minutes in the stated order, and then dried.

An ethanol solution of titanium isopropoxide adjusted to 2% was applied onto the surface of the FTO film by the spin coating method and then fired at 400°C for 10 minutes to form a thin film-shaped electron transport layer having a thickness of 20 nm. A titanium oxide paste containing polyisobutyl methacrylate as an organic binder and titanium oxide (mixture of powders having average particle sizes of 10 nm and 30 nm) was further applied onto the thin film-shaped electron transport layer by the spin coating method and then fired at 500°C for 10 minutes to form a porous electron transport layer having a thickness of 500 nm.

Subsequently, CH₃NH₃I and PbI₂ were dissolved at a molar ratio of 1:1 in N,N-dimethylformamide (DMF) as a solvent to prepare a solution for organic-inorganic perovskite compound formation having a total concentration of CH₃NH₃I and PbI₂ of 20% by weight. This solution was laminated onto the electron transport layer by the spin coating method to form a photoelectric conversion layer.

Further, 68 mM spiro-OMeTAD (having a spirobifluorene skeleton), 55 mM tert-butylpyridine and 9 mM lithium bis(trifluoromethylsufonyl)imide salt were dissolved in 25 µL of chlorobenzene to prepare a solution. This solution was laminated to a thickness of 300 nm onto the photoelectric conversion layer by the spin coating method to form a hole transport layer.

A gold film having a thickness of 100 nm was formed as a counter electrode on the hole transport layer by vacuum deposition to obtain a laminate.

### (Encapsulation of laminate)

The obtained laminate was set in a substrate holder of a sputtering device. Further, Si targets were mounted on cathode A and cathode B of the sputtering device. A film forming chamber of the sputtering device was evacuated using a vacuum pump to reduce the pressure to 5.0 × 10⁻⁴ Pa. Then, sputtering was performed under the Sputtering condition A shown below to form a 20 nm SiO₂ thin film as an inorganic layer on the laminate.

### <Sputtering conditions A>

Argon gas flow rate: 50 sccm, oxygen gas flow rate: 50 sccm
Power output: cathode A = 500 W, cathode B = 1,500 W

Next, 100 parts by weight of a dicyclopentadiene-type epoxy resin (HP-7200HH, available from Dainippon Ink and Chemicals) and 3 parts by weight of an imidazole curing agent (2E4MZ, available from Shikoku Chemical Corporation) were dissolved in 300 parts by weight of toluene. The obtained solution was applied to aluminum foil, and the organic solvent was dried to prepare aluminum foil with an encapsulation resin having a thickness of 10 µm. The inorganic layer was laminated with the obtained aluminum foil with an encapsulation resin at 80°C, followed by curing at 60°C for one hour. A solar cell was thus prepared.

### (Examples 2 to 11)

Each solar cell was obtained in the same manner as in Example 1, except that in encapsulation of the laminate, an inorganic layer (material, thickness) specified in Table 1 was formed by changing the metal target used in the sputtering method and the thickness of the inorganic layer.

In the case where a SnO₂ inorganic layer was formed, a Sn target was used as the metal target. In the case where a ZnSnO inorganic layer was formed, a ZnSn alloy (Zn:Sn = 95:5 (% by weight)) target was used. In the case where a ZnSnO(Si) inorganic layer was formed, a ZnSn alloy (Zn:Sn = 95:5 (% by weight)) target was used as the metal target for cathode A and a Si target was used as the metal target for cathode B. In the case where a ZnSnO(Al) inorganic layer was formed, a ZnSn alloy (Zn:Sn = 95:5 (% by weight)) target was used for cathode A and an Al target was used for cathode B.

### (Examples 12 to 15)

A solar cell was obtained in the same manner as in Example 2, except that in preparation of the laminate, the components contained in the solution for organic-inorganic perovskite compound formation was changed to form a photoelectric conversion layer (organic-inorganic perovskite compound) shown in Table 1.

In Example 12, CH₃NH₃Br, CH₃NH₃I, PbBr₂, and PbI₂ were dissolved at a molar ratio of 1:2:1:2 in N,N-dimethylformamide (DMF) as a solvent. In Example 13, CH₃NH₃I and PbCl₂ were dissolved at a molar ratio of 3:1 in N,N-dimethylformamide (DMF) as a solvent. In Example 14, CH₃NH₃Br and PbBr₂ were dissolved at a molar ratio of 1:1 in N,N-dimethylformamide (DMF) as a solvent. In Example 15, CH₃(NH₃)₂I and PbI₂ were dissolved at a molar ratio of 1:1 in N,N-dimethylformamide (DMF) as a solvent.

### (Examples 16 to 19)

Each solar cell was obtained in the same manner as in Example 2, except that in encapsulation of the laminate, an inorganic layer (material, thickness) specified in Table 1 was formed by changing the metal target used and the sputtering condition employed in the sputtering method.

In the case where an aluminum nitride (AlN) inorganic layer was formed, an A1 target was used as the metal target and the sputtering condition B was employed. In the case where a Si(O,N) inorganic layer was formed, a Si target was used as the metal target and the sputtering condition C was employed. In the case where a ZrO₂ inorganic layer was formed, a Zr target was used as the metal target and the sputtering condition A was employed. In the case where a MgO inorganic layer was formed, a Mg target was used as the metal target and the sputtering condition A was employed.

### (Sputtering condition B)

Argon gas flow rate: 50 sccm, nitrogen gas flow rate: 50 sccm
Power output: cathode A = 500 W, cathode B = 1,500 W (Sputtering condition C)
Argon gas flow rate: 50 sccm, nitrogen gas flow rate: 10 sccm, oxygen gas flow rate: 40 sccm
Power output: cathode A = 500 W, cathode B = 1,500 W

### (Examples 20 and 21)

Solar cells were obtained in the same manner as in Examples 2 and 7, respectively, except that lamination with aluminum foil was not performed in encapsulation of the laminate.

### (Examples 22 and 23)

Solar cells were obtained in the same manner as in Examples 2 and 7, respectively, except the following. In encapsulation of the laminate, to a PET film subjected to mold release treatment in advance was applied an encapsulation resin to form a film with a thickness of 10 µm, and the inorganic thin layer was laminated with the obtained PET film at 80°C. Then, the PET film alone was removed from the laminate to provide a solar cell.

### (Examples 24 and 25)

The solar cells were obtained through encapsulation of the laminate in the same manner as in Examples 2 and 7, respectively. Then, a SiO₂ film in Example 24 and a ZnSnO film in Example 25 each with a thickness of 100 nm were formed under the same sputtering conditions as in Examples 2 and 7, respectively. Solar cells of Examples 24 and 25 were thus prepared.

### (Examples 26 and 27)

Solar cells were obtained in the same manner as in Examples 2 and 7, respectively, except that in encapsulation of the laminate, a planarizing layer was introduced between the counter electrode and the inorganic layer. The planarizing layer was formed using a cyclohexane solution of a norbornene resin (TOPAS6013, available from Polyplastics Co., Ltd.) by a spin coating method.

### (Examples 28 and 29)

Each solar cell was obtained in the same manner as in Example 2, except that the inorganic layer was formed on the encapsulation material by EB vapor deposition or ion plating, not by sputtering, and that the inorganic layer was changed as specified in Table 2.

### (Examples 30 and 31)

Each solar cell was obtained in the same manner as in Example 26, except that the inorganic layer was formed on the encapsulation material by EB vapor deposition or ion plating, not by sputtering, and that the inorganic layer was changed as specified in Table 2.

### (Comparative Examples 1 to 3)

Each solar cell was obtained in the same manner as in Example 1, except the following: in preparation of the laminate, a solution (2% by weight chlorobenzene solution) of P3HT (polythiophene) (available from Aldrich) and PCBM (fullerene) (available from Aldrich) mixed at a ratio of 1:1 was applied as the organic semiconductor to a thin-film electron transport layer to a thickness of 200 nm by a spin coating method, instead of stacking a porous electron transport layer and an organic-inorganic perovskite compound on a thin-film electron transport layer; as a hole transport layer, a 3-fold diluted solution of PEDOT:PSS (available from Aldrich) in methanol, instead of Spiro-OMeTAD, was applied to a thickness of 50 nm by spin coating; and in encapsulation of the laminate, an inorganic layer (material, thickness) as specified in Table 2 was formed by changing the metal target used and the sputtering condition employed in the sputtering method.

### (Comparative Examples 4 and 5)

Solar cells were obtained in the same manner as in Example 1 and Comparative Example 1, respectively, except that, in encapsulation of the laminate, encapsulation using an inorganic layer was not performed but the laminate was directly encapsulated with the encapsulation resin.

### <Evaluation>

The solar cells obtained in Examples and Comparative Examples were evaluated as described below. Tables 1 and 2 show the results.

### (1) Photoelectric conversion efficiency before encapsulation (initial conversion efficiency)

A power source (236 model, available from Keithley Instruments, Inc.) was connected between the electrodes in the laminate before encapsulation. The photoelectric conversion efficiency was measured using a solar simulator (available from Yamashita Denso Corp.) having an intensity of 100 mW/cm², and the obtained value was taken as the initial conversion efficiency.
o (Good): Initial conversion efficiency was 4% or higher.
× (Poor): Initial conversion efficiency was less than 4%.

### (2) Degradation during encapsulation (initial degradation)

A power source (236 model, available from Keithley Instruments, Inc.) was connected between the electrodes in the solar cell immediately after encapsulation. The photoelectric conversion efficiency was measured using a solar simulator (available from Yamashita Denso Corp.) having an intensity of 100 mW/cm² to determine the value of photoelectric conversion efficiency immediately after encapsulation/initial conversion efficiency.
o (Good): The value of photoelectric conversion efficiency immediately after encapsulation/initial conversion efficiency was 0.5 or more.
× (Poor): The value of photoelectric conversion efficiency immediately after encapsulation/initial conversion efficiency was less than 0.5.

### (3) Durability

The solar cell was left for 24 hours under conditions of 90%RH and 60°C to conduct a durability test. A power source (236 model, available from Keithley Instruments, Inc.) was connected between the electrodes in the solar cell after the durability test. The photoelectric conversion efficiency was measured using a solar simulator (available from Yamashita Denso Corp.) having an intensity of 100 mW/cm², and the value of photoelectric conversion efficiency after the durability test/photoelectric conversion efficiency immediately after encapsulation was determined.
ooo (Outstanding): The value of photoelectric conversion efficiency after durability test/photoelectric conversion efficiency immediately after encapsulation was 0.95 or more.
oo (Excellent): The value of photoelectric conversion efficiency after durability test/photoelectric conversion efficiency immediately after encapsulation was 0.9 or more and less than 0.95.
o (Good): The value of photoelectric conversion efficiency after durability test/photoelectric conversion efficiency immediately after encapsulation was 0.7 or more and less than 0.9.
△ (Average): The value of photoelectric conversion efficiency after durability test/photoelectric conversion efficiency immediately after encapsulation was 0.6 or more and less than 0.7.
× (Poor): The value of photoelectric conversion efficiency after durability test/photoelectric conversion efficiency immediately after encapsulation was less than 0.6.

### (4) Comprehensive evaluation

o (Good): None of the (1) to (3) was rated × (Poor).
× (Poor): One or more of the (1) to (3) was rated × (Poor).

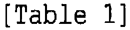

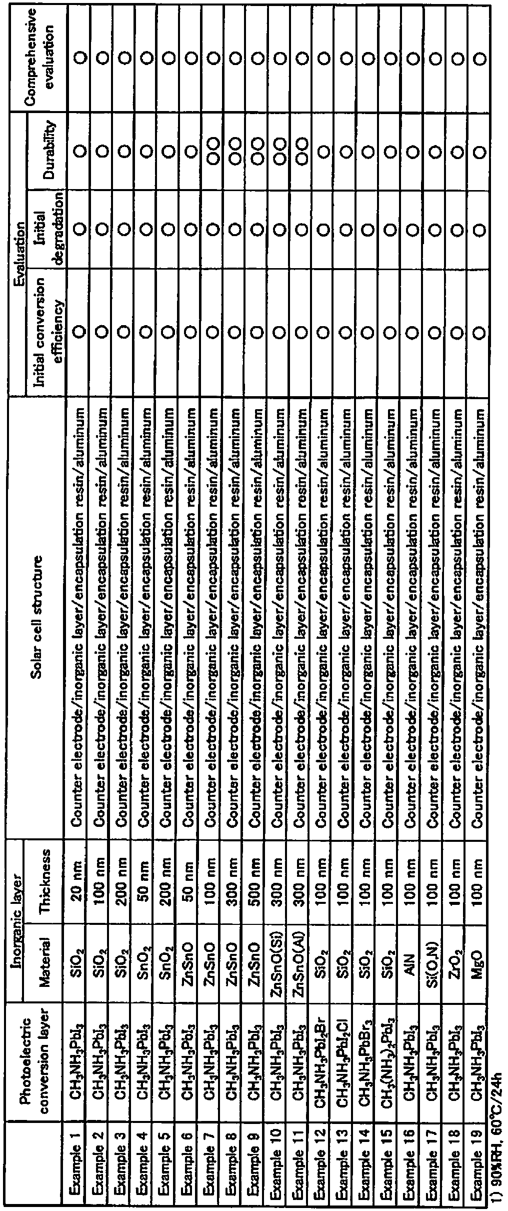

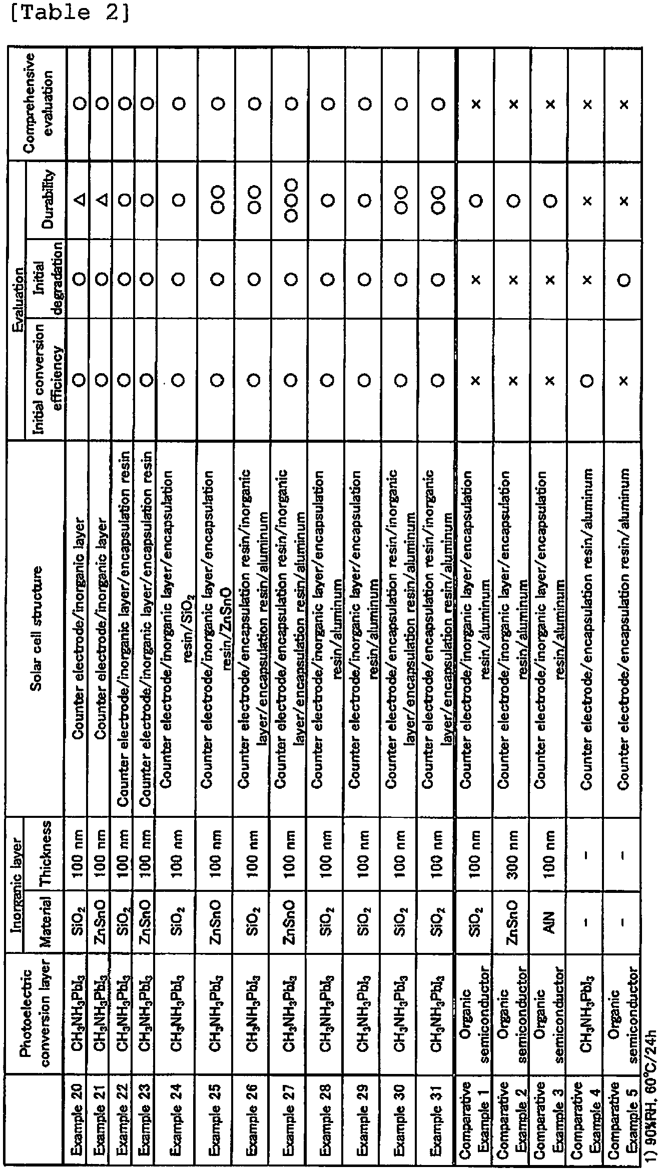

### INDUSTRIAL APPLICABILITY

The present invention can provide a solar cell that is excellent in photoelectric conversion efficiency, suffers little degradation during encapsulation (initial degradation), and has excellent durability.

### REFERENCE SIGNS LIST

- 1:: solar cell
- 2:: electrode
- 3:: counter electrode (patterned electrode)
- 4:: photoelectric conversion layer
- 5:: inorganic layer
- 6:: substrate

## Claims

1. A solar cell comprising:
a laminate having an electrode, a counter electrode, and a photoelectric conversion layer disposed between the electrode and the counter electrode; and
an inorganic layer covering the counter electrode to encapsulate the laminate,
the photoelectric conversion layer including an organic-inorganic perovskite compound represented by the formula: R-M-X₃, R representing an organic molecule, M representing a metal atom, X representing a halogen atom or a chalcogen atom,
the inorganic layer containing a metal oxide, a metal nitride, or a metal oxynitride.

2. The solar cell according to claim 1,
wherein the inorganic layer contains an oxide, a nitride, or an oxynitride of Si, Al, Zn, or Sn.

3. The solar cell according to claim 1,
wherein the inorganic layer contains an oxide, a nitride, or an oxynitride of Zn or Sn.

4. The solar cell according to claim 1,
wherein the inorganic layer contains an oxide, a nitride, or an oxynitride of metal elements including both Zn and Sn.

5. The solar cell according to claim 1,
wherein the inorganic layer contains a metal oxide represented by the formula ZnₐSn_{b}O_{c} where a, b, and c each represent a positive integer.

6. The solar cell according to claim 1, 2, 3, 4, or 5,
wherein the inorganic layer has a thickness of 30 to 3,000 nm.

7. The solar cell according to claim 1, 2, 3, 4, 5, or 6,
wherein the solar cell further includes a planarizing resin layer disposed between the counter electrode and the inorganic layer.

8. The solar cell according to claim 1, 2, or 3,
wherein the solar cell further includes an encapsulation resin layer on the inorganic layer.
